# EUROPEAN PATENT SPECIFICATION

(11) **EP 0 830 253 B1**
(45) Date of publication and mention of the grant of the patent: **28.08.2002**
(21) Application number: 96916936.6
(22) Date of filing: 03.06.1996
(51) Int. Cl.: B41J 29/38, H05K 7/16, B41J 29/02

(54) **A PRINTER FOR A DRIVE BAY**
DRUCKER FÜR PLATTENABTEIL
IMPRIMANTE POUR BAIE D'UNITE

(30) Priority: 06.06.1995 US 470921
(43) Date of publication of application: 25.03.1998
(73) Proprietor: CYCOLOR, INC., Miamisburg, Ohio 45342 (US)
(72) Inventor: CAMILLUS, Joseph, C., Miamisburg, OH 45342 (US); WHITAKER, Tyson, B., Miamisburg, OH 45342 (US); GOMI, Masao, Miamisburg, OH 45342 (US)
(74) Representative: Howden, Christopher Andrew
(86) International application number: US9608305
(87) International publication number: WO96039301

(56) References cited:
- EP-A- 0 571 158
- GB-A- 2 133 222
- US-A- 4 436 439
- US-A- 4 547 786
- US-A- 4 783 669
- US-A- 4 810 111
- US-A- 4 853 713
- US-A- 5 020 926
- US-A- 5 047 789
- US-A- 5 121 343
- US-A- 5 212 628
- US-A- 5 214 574
- US-A- 5 257 197

## Description

### Background of the Invention

The present invention relates to a printer which fits within a conventional personal computer housing and, more particularly, to a small format printer which fits within the dimensions of a conventional accessible drive bay in a personal computer housing.

Conventionally, with few exceptions, unlike many personal computer accessories such as disc drives, modems, and the like, computer printers have been stand alone accessories that have not been housed within the personal computer itself. While printer technology has developed in recent years to the point that faster, higher resolution, and full color printers are now widely available at affordable prices, there are certain applications in which it would be desirable to house a printer within a personal computer housing. In particular, it would be desirable if a printer could fit within the dimensions of the conventional accessible disc drive bay in this housing. While the size of this printer would limit the size of the media that it would employ and the size of the image it would produce, such a printer could be an optional accessory that is assembled with the computer chassis similar to a CD ROM drive, a floppy drive, or an additional hard drive and used to print documents, facsimiles, image files (e.g., bitmaps), or graphics analogous to a conventional printer, or such a printer could be dedicated to printing facsimiles or printing photographic quality images downloaded from a TV or video file in a reduced size or format. The conventional stand alone printer might be used for text document preparation whereas the drive bay housed printer might be used to reproduce full color near photographic quality images having a size comparable to a standard photograph.

A drive bay housed full color, near photographic quality printer would be useful in a variety of applications currently available or rapidly moving towards market introduction. Kodak Corporation currently provides a service in which films and negatives can be placed on photo CD discs and photo CD access software allows the user to load the images into the personal computer memory, view the images, edit the displayed image by cropping or changing the size, color settings and orientation, and copy the original or edited image as a bitmap. In addition, while not widely used, electronic digital cameras are commercially available currently. These cameras photograph an image, but the image is stored in digital memory such as random access memory instead of on film. These stored images can be downloaded from the camera to a personal computer for viewing and editing in a manner analogous to the photo CD images discussed previously. In still another application, personal computers are now available commercially with television cards. With a TV card, the user can download images directly from the television network or from a video recorder for viewing and editing. Alternatively, the drive bay housed printer might be used to print images from a source such as the Internet.

US-A-4,436,439 discloses a small printer provided in a portable electronic calculator, the printer being configured to print characters on a printing medium. The printer disclosed in this document is not suitable for use in the drive bay of a personal computer and furthermore cannot produce full color, photographic quality images by disposing and developing photosensitive media.

US-A-5,121,343 discloses a computer printing system for producing 3-D stereoscopic hard copy outputs from computers. However, the printer of this disclosure cannot be housed within an accessible drive bay of a personal computer. Furthermore, in the printer of US-A-5,121,343, the printing media is caused to move whilst the print head remains stationary. It has been found that this type of arrangement is difficult to make sufficiently compact such that the printer may be accommodated within the drive bay of a personal computer.

In summary, there is a need for a printer that can be housed within a personal computer accessible drive bay. In particular, as the capabilities of the personal computer expand in the video and photographic field, the need for printers which can reproduce near or photographic quality images will increase and it would be desirable if such a printer could be housed within a conventional personal computer disc drive bay. Such a printer could reproduce images approximately the size of a conventional photograph, for example, about (3 inches) 76.2 mm wide and (5 inches) 127 mm long. Such a printer would not replace the stand alone printer but it would provide a low cost alternative which would enable the personal computer to be used for additional applications.

### Summary of the Invention

According to a first aspect of the present invention, there is provided a personal computer for reproducing full colour, photographic quality images by exposing and developing a photosensitive media, the computer comprising: a housing (T), an accessible drive bay in the housing and a printer, wherein said printer is housed within said drive bay and said printer includes a media access for receiving a supply of full colour photosensitive media, said printer including a printhead comprising a plurality of modulated radiation emitting elements, said printer further including a motor for driving said printhead along a linear path to scan said media and expose said media to radiation to produce full colour, photographic quality images therein.

According to a further aspect of the present invention, there is provided a printer which is adapted to be housed within an accessible drive bay of a computer, the printer comprising: a media access for receiving a supply of full color photosensitive media to be exposed, a communication link for receiving image data from a computer, a printhead for printing said media, and means for mounting said printer in said bay, said printhead comprising a plurality of modulated radiation emitting elements and a motor for driving said printhead along a linear path to scan said media and expose said media to radiation to produce full colour, photographic quality images therein.

The present invention provides a printer which fits within the dimensional confines of a personal computer disc drive bay, such as a half high 133.4 mm (5¼ inch) accessible drive bay.

The preferred printer includes a printhead, access for a media supply cartridge, a communication port for receiving print signals and image information, and a media conveyor for transporting the media through the printer for printing or dispensing or ejecting the media from the printer. Where the media requires a latent image to be developed, the printer may also include a developer such as a pressure head or pressure roller or a means to heat the media. Examples of printing methodologies which can be used in the printer include dot matrix, ink jet, pen plotter, dye diffusion thermal transfer (D2T2) and photosensitive methodologies such as, conventional photographic film, the diffusion transfer color photographic or "instant" film unit, (e.g., a POLAROID film unit), a film unit employing photohardenable microcapsules such as the CYCOLOR media developed by The Mead Corporation or photographic systems such as those described in U.S. Patent 5,091,280 and 5,198,468 to Fuji Photo Film Company Limited.

The invention will be specifically illustrated with reference to the photosensitive media developed by The Mead Corporation which employs a developer and microcapsules containing a color precursor and a photohardenable composition. This media is designed to be image-wise exposed to actinic radiation to form a latent image in the form of hardened, partially hardened, and unhardened microcapsules. By applying pressure to a layer of the microcapsules, the microcapsules rupture and differentially release the color precursor. The released color precursor is free to react with a solid acidic developer material which is provided within the media. The color precursor migrates to the developer where it reacts to form a full color image. This photographic system is described in more detail in commonly assigned U.S. Patents 4,399,209; 4,416,966; 4,440,846; 4,751,165; 4,766,050; 4,842,981; 4,842,976; and 4,912,014. A photosensitive media that is specifically designed for use in conjunction with the printer disclosed herein is described in co-pending U.S. Application Serial Number 08/258,329 filed June 10, 1994.

The design of the printer and the selection of the media and the printhead can vary depending on the type of image the printer is designed to reproduce and the resolution and color quality desired in the image. For printing text a thermal printhead or an ink jet printhead may be used. For producing full color photographic images using a photosensitive media, the printhead includes exposure elements such as light emitting diodes (LED), a liquid crystal display (LCD) panel or a cathode ray tube such as a fiber optic cathode ray tube or a similar source of modulated radiation. The printhead may scan the media by moving the media with respect to the printhead or moving the printhead with respect to the media in an X and/or Y direction or, in certain embodiments, the printhead may be a stationary panel such as an LCD the size of which corresponds to the area of the image to be reproduced. With certain photosensitive media, such as Polaroid or Mead film units the printer also includes a developer unit for converting latent images formed in the media by the exposure to the printhead into visible images. The developer unit may be a pressure roller to rupture the microcapsules in the case of Mead's photographic system or a device to rupture a pod containing developer solution in the case of a Polaroid material.

### Brief Description of the Drawings

Fig. 1 is a perspective view of a conventional personal computer housing sometimes referred to as a "tower".
Fig. 2 is a perspective view of a computer printer in accordance with the present invention which fits within a conventional disc drive bay.
Fig. 3 shows the printer of Fig. 2 with an associated media pack wherein a print is shown in the process of being dispensed from the printer.
Fig. 4 is a cross-sectional view of the printer of Fig. 2 showing the path through which the media is transported in forming an image.
Fig. 5 is a side view of the printer of Fig. 2 showing the gear train.
Fig. 6 is a top view of the printer of Fig. 2.

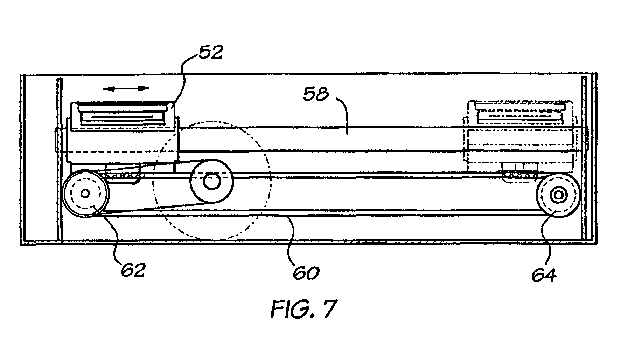

Fig. 7 is a cross-sectional schematic view of the printer shown in Fig. 6 along the line 7-7.
Fig. 8 is a side cross-sectional view of a printer for use with diffusion transfer photographic film, such as the Polaroid film product.
Fig. 9 is a side cross-sectional view of a printer employing dye diffusion thermal transfer media.
Fig. 10 is a side cross-sectional view of a printer employing an ink jet printhead.
Fig. 11 is a side cross-sectional view of a printer for thermal autochrome media.
Fig. 12 is a side cross-sectional view of a printer for 35mm photographic film.

### Definitions

The term "personal computer" or "PC" as used herein means a general-use computer created for a single user in an office or home which executes user-written or user-designated programs, performs user-designated data manipulation including arithmetic operations and logic operations. The term includes tower, desktop and laptop computers.

### Detailed Description of the Invention

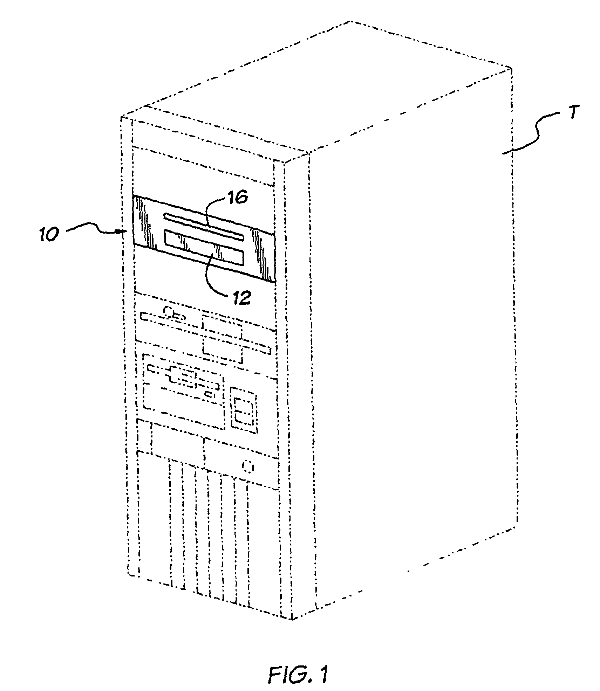

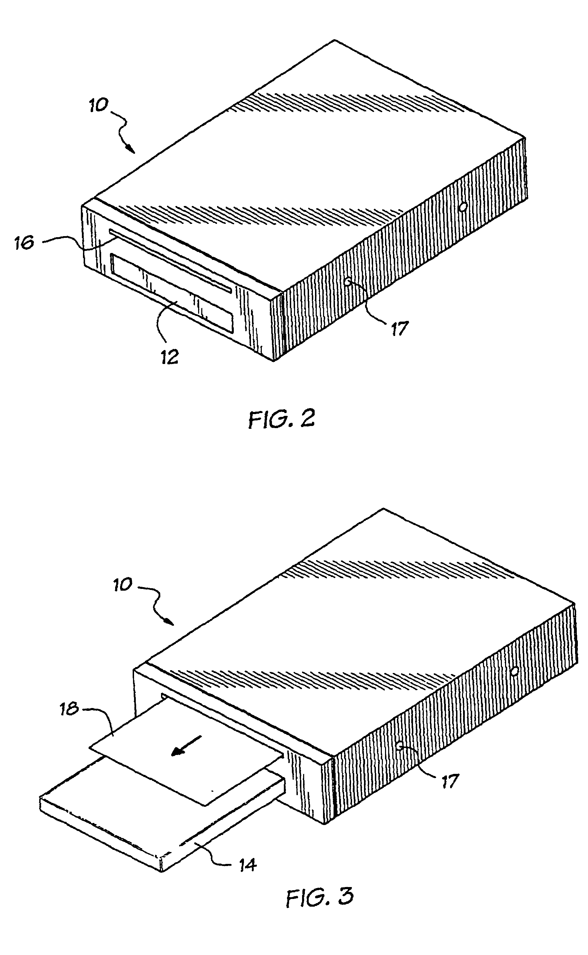

The invention will be illustrated in more detail by reference to the following specific embodiments. Those skilled in the art will readily appreciate that modifications and variations on these embodiments are possible without departing form the scope of the invention defined herein. Fig. 1 illustrates a conventional personal computer tower showing a printer 10 housed in one of the disc drive bays. The printer 10 includes a doored opening 12 through which the media cartridge 14 can be inserted as shown in Fig. 3 and a slot 16 from which the print 18 is dispensed from the printer. The printer shown in Fig 1 includes an industry standard half high accessible drive bay. Threaded mounting holes 17 are provided on each side of the printer 10. These holes align with slots in the computer chassis so that the printer can be fixed in the accessory bay by means of a threaded fastener. The media cartridge 14 is designed to supply the media in the form of individual sheets, but the media could easily be supplied in roll form if the printer included a slitter for separating the prints 18 from the roll before they were dispensed from the printer. The media supplied by cartridge 14 can be any of the previously mentioned media used in conventional stand alone printers, video printers or facsimile machines. It will also be recognized that it is not necessary to feed the media into the printer from a cartridge. Single sheets can be manually inserted into a slot in the printer from which they are taken up by the feed rollers.

A tower style personal computer having a half high drive bay has been selected to illustrate the invention. Other style housings such as desk top housings and laptop housings having full size or quarter size (3 1/2 inch) 88.9 mm drive bays can also be used. One of the essential attributes of the invention is that the printer is designed to be housed within the personal computer drive bay. Personal computer housings are distinguished by their single-user purpose. This restricts the size of any printer that can be housed in the computer. The present invention provides a printer which fits within a space about (1 to 4 inches) 25.4 to 101.6 mm high, (4 to 12 inches) 101.6 mm to 304.8 mm deep, and (3 to 7 inches) 76.2 to 177.8 mm wide. More particularly, the printer of the present invention is designed to fit with a space (1 to 2 inches) 25.4 to 50.8 mm high, (7 to 9 inches) 177.8 to 228.6 mm deep and (5.5 to 6.5 inches), 139.7 to 165.1 mm wide.

Currently, a typical personal computer housing contains within it a central processing unit (CPU) , memory (RAM), a data retrieval and storage device such as a hard disc drive, connections for input/output (I/O) devices (e.g., a keyboard, mouse and monitor) and a power supply. As the cost of memory continues to decrease, in future personal computers the hard drive may be replaced by RAM. Optionally, the PC may include a modem, a device for retrieving externally stored data such as a "floppy" drive or a CD ROM drive, a sound card and the like. In the case of a laptop, the housing also includes the input/output devices. For convenience the printer may be supplied with an expansion board which would be connected by a communication bus to the microprocessor board and to the printer. The printer would be powered by the computer's power supply but it is also envisioned that the printer could be powered by a battery pack carried in the media cartridge similar to a the way Polaroid film packs include battery packs to power instant cameras.

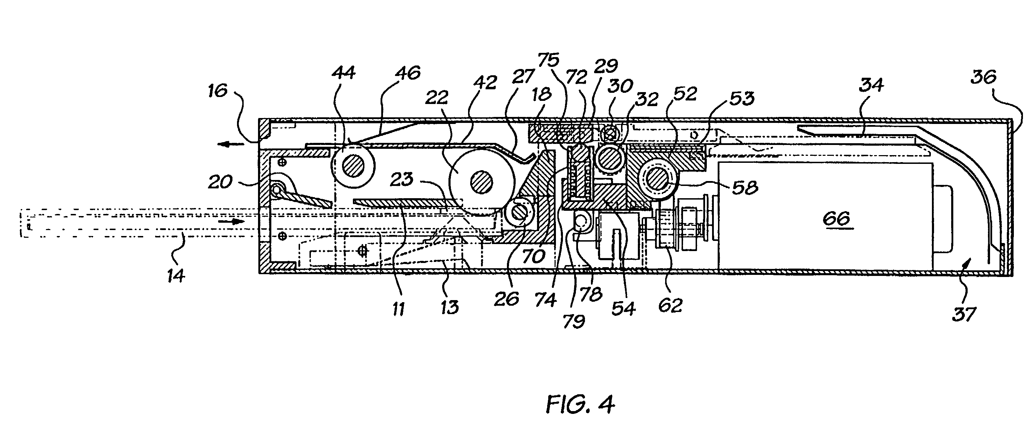

By inserting the media cartridge 14 into the slot 12, door panel 20 is rotated to an open position. The cartridge is positioned in the printer with the aid of a guide plate 11 and a spring element 13, which urges the cartridge into alignment with that plate. With the cartridge 14 in place in the printer, the pick up roller 22 begins to rotate when the printer 10 receives a print signal from the computer. If the cartridge 14 has not previously been opened, the roller 22 may open the unit by unfolding a closure flap 23. The pick up roller 22 is cam driven by a gear 21a in the gear train 19. With rotation of the roller 22, the first sheet of media is moved by roller 22 into the nip between the roller 22 and a roller 26. Roller 26 is designed to provide a slight rotational drag on the media. In this way if two or more sheets of media are fed at one time, roller 26 will scrape the additional sheets from the back side of the intended sheet to assist in preventing double feeding. With continued rotation of roller 22, the media sheet is removed from the media cartridge 14 and moved upwardly (as shown in Fig. 4) along ramp 18 where it is directed by baffle 27 and support plate 29 into the nip between line feed roller 32 and idle rollers 30.

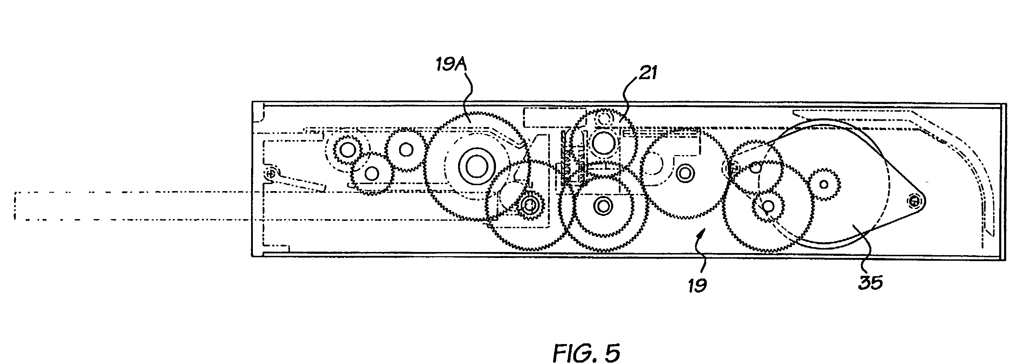

Rollers 22 and 32 are driven by a motor 35, which is conveniently but not necessarily a step motor, via gear train 19, as shown in Fig. 5. While roller 22 is cam driven, roller 32 is directly driven by gear 21. As a result of the different drives used in rollers 22 and 32, roller 32 transports the media faster than the roller 22.

In the illustrated embodiment, the printer 10 includes an optical detector 40 which senses the trailing edge of the media as it travels in the printer. The step motor 35 is programmed to transport the media sheet a predetermined number of steps corresponding to a predefined position in the printer upon receiving a signal triggered by a signal from the detector 40 indicating the trailing edge of the media sheet. The feed roller 32 in conjunction with a plurality of idle rollers 30 transport the sheet a fixed number of steps as programmed by the step motor 35 to the guide plate 34 at the back 36 of the printer. The guide plate 34 is curved in order to direct the leading edge of the media sheet into the open space 37 in the back of the printer. When the media reaches this predefined position, the step motor 35 is programmed to reverse and the counter in the step motor controls the advancement of the media through the printer. Advancement of the media from this point in the operation of the printer is coordinated with the programming and operation of the printhead 52 such that upon completing each scan of the media by the printhead, the media is advanced. When the motor 35 reverses direction, the direction of rotation of roller 22 is also reversed by switching the drive for the roller 22 to the gear train 23 on the opposite side of the printer. By reversing the direction of the roller 22 in this manner, the roller 22 can urge any media sheet which may have been double fed and detained by roller 26 back into the media supply cartridge unit thereby preventing double feeds.

While the invention is illustrated using pick up and feed rollers to convey the media through the printer, other sheet conveyance means conventionally employed in printers or copiers such as belt conveyors may also be useful.

The printhead used to illustrate this particular embodiment of the invention is also described in U.S. Patent No. 5,550,627 filed April 6, 1995. In the embodiment illustrated in Figs. 4-6, the printhead 52 includes a single carriage element on which both an exposure head 53 and a developing head 54 are carried. These two elements can be divided and deployed on separately driven carriages if desirable. The exposure head 53 image-wise exposes the media. In this case, as previously indicated the printer is designed to print on a photosensitive media employing photohardenable microcapsules but other photosensitive media could be exposed in a similar manner as has also been previously described. The developer head 54 ruptures the microcapsules after exposure. The exposure head 53 incorporates a plurality of modulated radiation (light) emitting elements 55 which may be in the form of light emitting diodes (LED), liquid crystal display (LCD) panels, lasers, fiber optics, etc. Preferably the radiation emitting elements 55 are red, green and blue LED's mounted in the exposure head 53. The radiation emitting elements are modulated by an electronic signal provided from the computer and, more particularly from an expansion board supplied with the printer and assembled with the computer. The expansion board may include a print buffer or interface circuitry in a manner known in the art. The radiation emitted by elements 55 can be directed to the media sheet through a beam-forming aperatured plate 56 positioned adjacent to the LED's whereby the radiation is projected onto the media sheet with good resolution.

The printhead 52 travels back and forth across the media on the carriage rail 58. The printhead is clamped to and driven by a cog belt 60 which runs parallel the rail 58 on a pair of rollers 62 and 64 oriented such that their center axes are horizontal. Roller 62 is indirectly driven by a step motor 66. This step motor is programmed such that at the end of each stroke or traverse of the media by the printhead 52 the motor reverses direction. Immediately before the step motor 66 reverses the direction of the printhead, the media is incrementally advanced by the line motor 35.

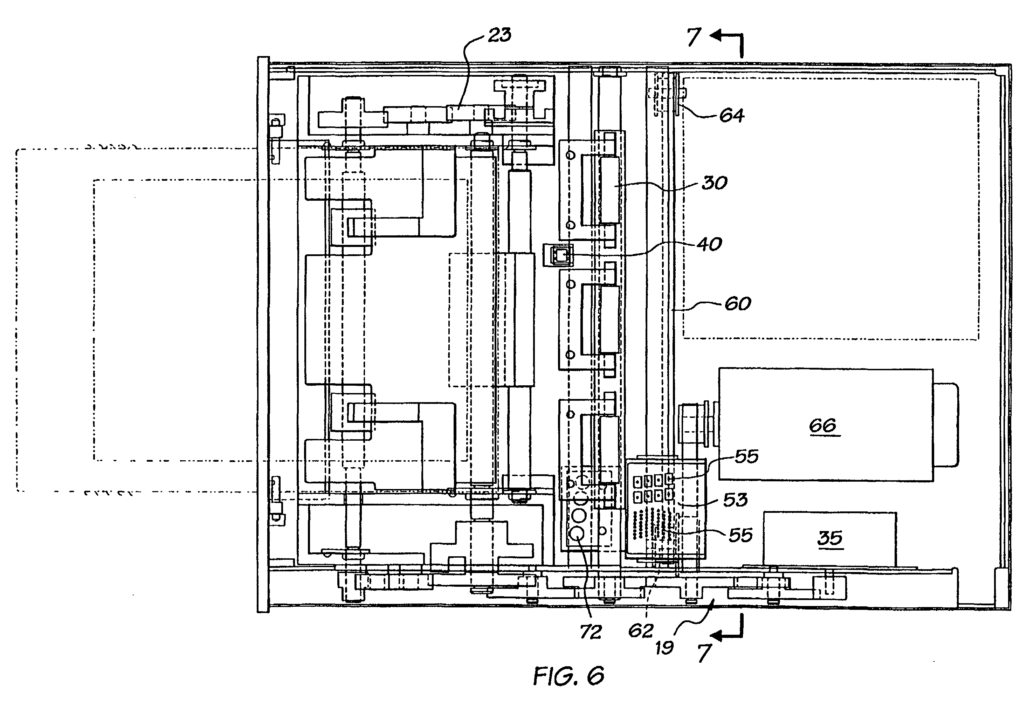

As the media is step-wise exposed and incrementally advanced, the media passes between an overhead pressure plate 29 and the developer head 54. The developer head 54 includes a pressure applicator 70 including at least one and preferably a plurality of ball elements 72. In Fig. 6, the pressure applicator includes four ball elements which are arranged on a line which runs at an oblique angle with respect to the direction of travel of the printhead such that the elements travel along a plurality of overlapping paths as they cross the media. The ball elements are preferably arranged so as to avoid forming raster lines in the image. The ball elements are each mounted in a cylindrical bore 75 with a compression spring 74 which urges each ball into pressure contact with the media. The developer unit 54 is supported on a rail member 78 as it traverses the media. The media is compressed between the ball elements and the upper pressure plate 29. This causes the microcapsules to rupture whereupon the color precursor contacts the developer material and produces an image.

There are occasions during the operation of the printer when it is not desired to have the pressure balls contact the media such as when the media is transported to the back of the printer prior to printing and as the border regions (which are optional) such as the areas immediately adjacent and parallel the leading and trailing edges of the media, passes over the developer head 54. To prevent such contact the rail 78 is rotatable about its center axis and has a noncircular cross-section including a flat 79 over a portion of its length adjacent one or both sides of the printer. By moving the printhead to a side location and rotating the flat into position beneath the printhead, the ball elements do not contact the media.

The printer is programmed such that the media continues to be advanced, exposed and developed until the image is complete. The printer may optionally include a heating element such as a heated bar which extends across the media path to heat the media as it exits the printer and thereby accelerate development if desired. Completion of the image may be indicated by a signal from the computer, or by a signal generated directly or indirectly in response to the detection of the leading or trailing edge of the media by optical detector 40. Upon completing the image, the printhead is positioned to the side of the printer, the pressure head is disabled by rotating rail 78 as described above and the media is advanced along table 42 to roller 44 which is driven by the gear train shown in Fig. 5 and which advances the media out of exit slot 16. The media is held in contact with roller 44 by the spring baffle 46. Once the print has been ejected through slot 16, the line motor 35 is reversed and upon receiving the next print signal, the printer is ready to remove another sheet of media from the media pack 14 and to repeat the printing operation.

While the printer discussed above is designed for use with a photosensitive media employing microencapsulated color formers, the teachings herein and the invention go well beyond the specific printer illustrated or processing this particular media. As illustrated below, through the use of other printheads other media may be processed within the personal computer housing to provide images based on the teachings herein.

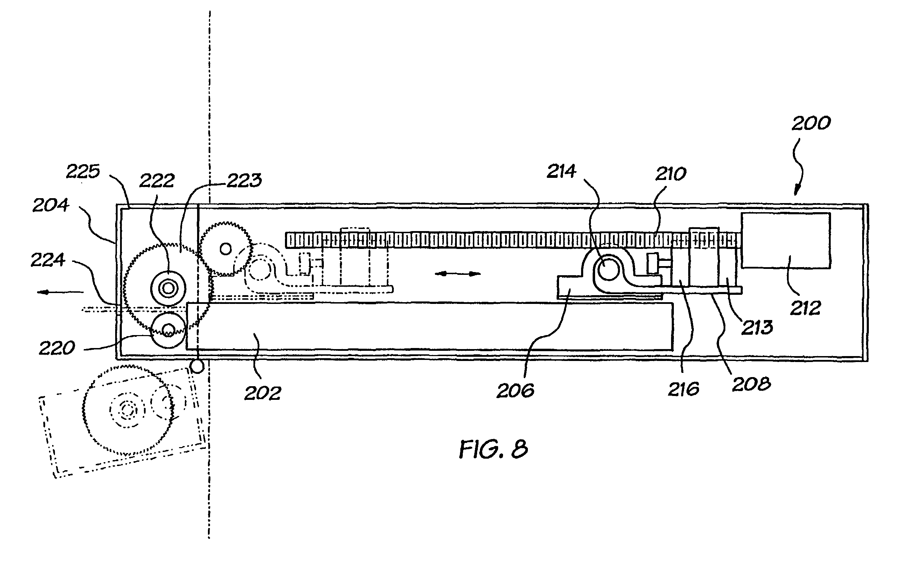

Fig. 8 illustrates a printer 200 in accordance with another embodiment of the invention which is designed to print on a Polaroid film pack 202. The printer 200 extends forwardly from the front face of the computer to permit a door 204 to swing downwardly to load the film pack. In this embodiment, the media is not moved with respect to the printhead as was the case for the previous embodiment. Instead each film unit is exposed as it sits in the film pack using an exposure head 206 which scans the film in both an X and Y direction. An exposure head 206 carrying LED's (not shown) is mounted on a carriage 208. The carriage is moved in the X direction (i.e., right and left as shown in Fig. 8) by a ball screw 210 which is driven by a step motor 212. The ball screw passes through a threaded aperture in a carriage support member 213. A second carriage support member is located on the opposite side of the printer and travels on an unthreaded guide rail running parallel to and in alignment with the screw 212. The Y scan of the exposure head 206 is provided in a manner analogous to that shown in Fig. 5. The carriage 208 extends across the printer and includes a carriage rod 214 on which the exposure head 206 is moved by belt drive 216 which is also carried on the carriage 208. The belt drive is driven by a separate step motor which is not shown. When the film unit has been completely scanned, the film unit can be pushed out of the film pack by a pic in manner known in the art into the pressure nip between the developer rollers 220 and 222 which are mounted on the printer door 225. Roller 222 is driven by gear 223 which intermeshes with the line gear train in the printer when the door 225 is closed. As the film unit is dispensed through slot 224, a developer pod in the film unit is ruptured. If the film unit 202 includes a battery pack, contacts can be provided on the floor of the printer so that the step motor 212 for the X-drive and the unshown step motor for the belt drive can be powered by the battery pack. Alternatively, the motor can be powered by D.C. current from the computer's power supply.

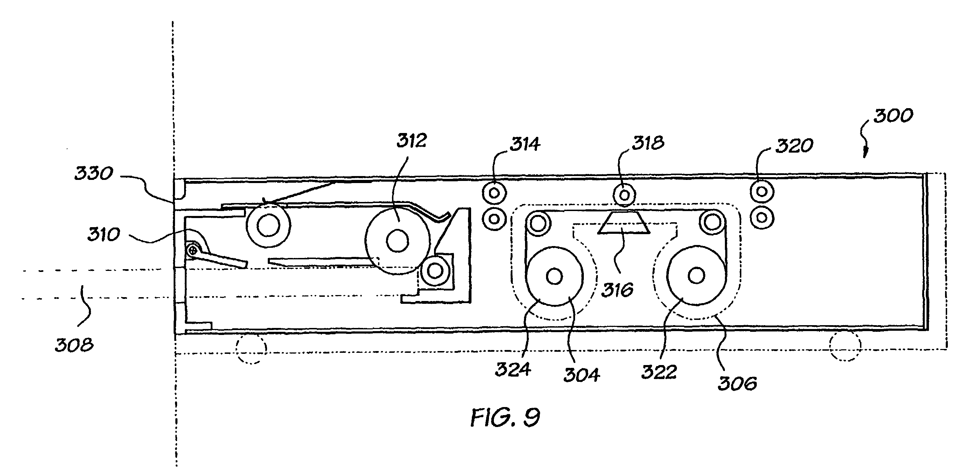

Fig. 9 illustrates a printer 300 which is useful in imaging by dye diffusion thermal transfer (D2T2). This system employs sublimable dyes carried on a ribbon. The printer 300 is mounted in the printer on drawer carriage 302 so that the printer 300 can be pulled from the front of the computer to replace the thermal transfer ribbon 304 which is installed in the printer on a cassette 306. Media 308 is supplied from a cartridge, which is inserted into the printer through door 310, using a pick up roll 312 in a manner analogous to that shown in Fig. 5. The media is fed by rollers 314 and 320 across a thermal printhead 316. Printhead 316 scans the media back and forth in one direction perpendicular to the media path. A back up roll 318 is provided to keep the media in proximate contact with the ribbon 304 as it is scanned by the thermal printhead. The ribbon 304 advances with the media during the printing process. The ribbon typically includes fields or panels which are cyan, magenta, yellow and black and correspond in length and width to the length and width of the area in the media in which the image is formed. One pass through the printhead is required for each color. Thus, to form a full color image using a four color ribbon, the printhead must scan the media four times.

In one embodiment of the invention, the media is transported by rollers 314 and 320 to the back of the printer whereupon the direction of rollers 314 and 320 is reversed. The media is printed as it passes from right to left in Fig. 9. As the media moves past the printhead 316, the thermal transfer ribbon moves in register with the media from the feed roll 322 to the take up roll 324 in the cassette 306. After each color is printed, rollers 314 and 320 are reversed, the media is translated to the back of the printer, the direction of the rollers is again reversed and the next color is printed as the media again moves from right to left in Fig. 9 in register with the print ribbon. After all of the colors have been printed, the media is advanced out of the printer through slot 330.

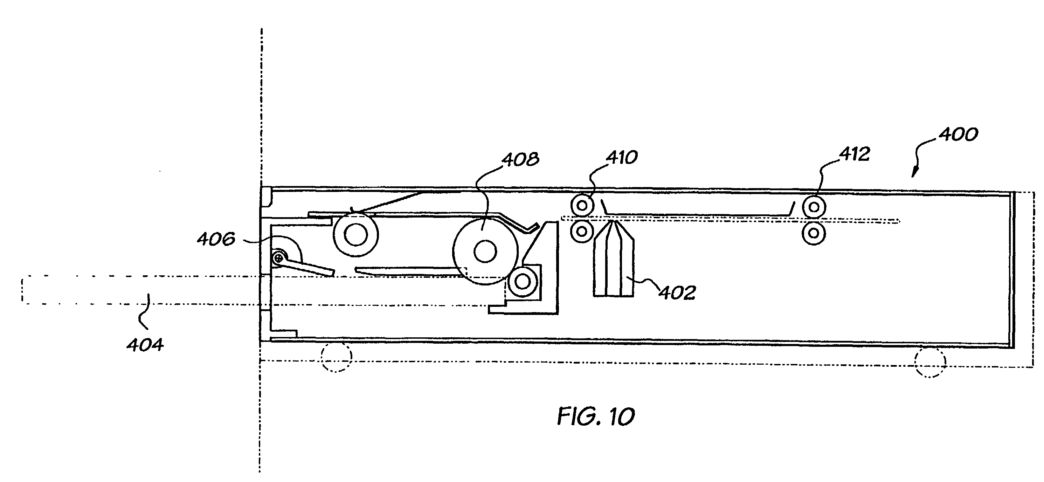

Fig. 10 illustrates a printer 400 which is designed to print images using an ink jet printhead 402. The media supply, pick up and line feed is similar to that shown in Fig.4. As shown in Fig. 10, the media 404 is inserted into the printer through door 406, the media is removed from the cartridge by pick up roll 408 and fed by feed rollers 410 and 412 to a position in the printer from which it is scanned by the printhead 402. Printhead 402 can be a conventional single color, three color or four color ink jet printhead which scans the media across its direction of travel. The ink is supplied to the printhead 402 in a cartridge (not shown). To permit replacement of the ink cartridge, the printer 400 is mounted in the printer on a drawer mechanism 414 which enables the printer to be slid out of the drive bay to a position at which the user can replace the ink cartridge and then slide the printer on the drawer carriage back into the drive bay.

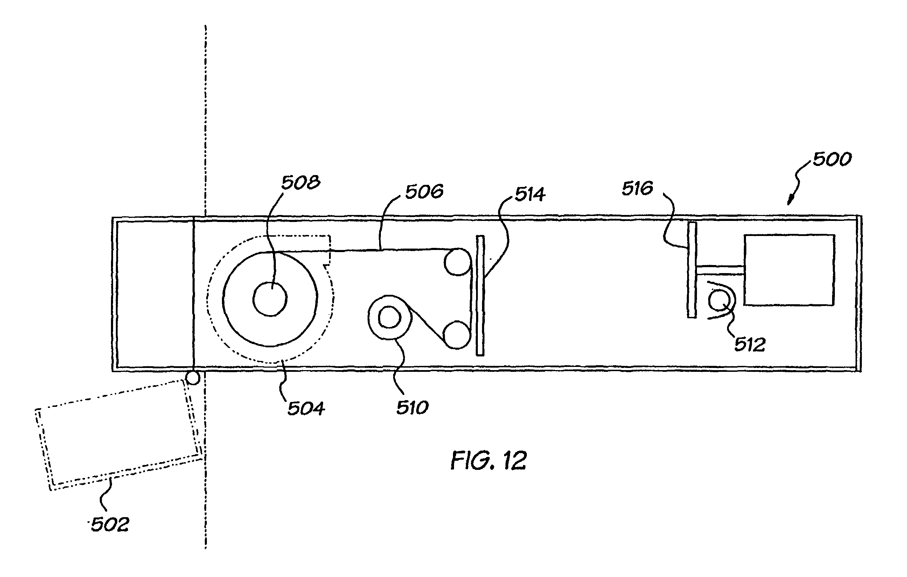

Fig. 12 illustrates a printer 500 which is useful in printing 35mm film. The printer 500 extends forwardly from the front face of the computer and includes a door 502 which swings downward to an open position to permit insertion of a 35mm film cartridge 504. Film 506 is pulled out of the film cartridge 504 by a driven reel 510 in a manner analogous to conventional cameras having an automatic film advance. In this embodiment, the printer is provided with an full frame LCD panel 514. This panel is controlled by a signal received from the computer. Images are formed on the film 506 as it stops in front of the panel 514. A white light source 512 is provided in the printer with a color filter wheel 516. Imaging information is downloaded to the LCD panel 514 in red, green, and blue fields. As each field of information is provided to the panel 514, the panel is illuminated by light source 512 through the corresponding filter on wheel 516. When the three exposures are complete, the film 506 is advanced and the next image can be formed. When all of the film has been paid out of the cartridge 504 or the user desires to interrupt imaging the film, the spool 508 can be actuated to wind the film back into the cartridge in a conventional manner. The cartridge can then be removed from the printer through door 502 and replaced.

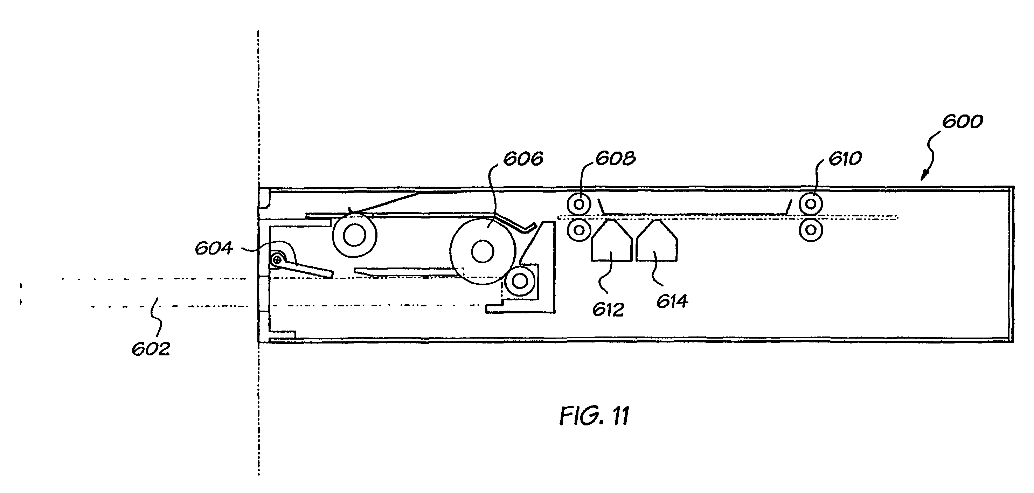

Fig. 11 illustrates a printer 600 which is useful in printing thermal autochrome media, as described in U.S. Patent 5,091,280 to Fuji Photo Film Company Limited. In this printer, a photosensitive media is supplied from a cartridge 602 which is inserted into the printer 600 through a door 604. Again, the media is advanced to the printhead using a pick up roller, as previously described. The thermal autochrome media requires exposure at three different wavelengths to expose the media which are typically in the ultraviolet or blue region. After exposure, the media is heated to develop the full color image. In the embodiment illustrated, a unit of the film is advanced by rollers 608 and 610. The printer includes a printhead 612 including modulated sources of radiation and a heating unit 614. In the embodiment illustrated in Fig. 11, the film unit is exposed as it moves from left to right in the figure and passes over the printhead 612. The printhead 612 carries light or UV radiation sources which correspond to the sensitivity of the media. After the media is exposed, it is heated to develop the image.

Having described the invention in detail and by reference to preferred embodiments thereof, it will be apparent that modifications and variations are possible without departing from the scope of the invention defined in the appended claims.

## Claims

1. A personal computer for reproducing full colour, photographic quality images by exposing and developing a photosensitive media, the computer comprising: a housing (T), an accessible drive bay in the housing and a printer (10), wherein said printer (10) is housed within said drive bay and said printer (10) includes a media access (12) for receiving a supply (14) of full colour photosensitive media, said printer including a printhead (52) comprising a plurality of modulated radiation emitting elements (55), said printer (10) further including a motor (66) for driving said printhead (52) along a linear path to scan said media and expose said media to radiation to produce full colour, photographic quality images therein.

2. The personal computer of claim 1 wherein said modulated radiation emitting elements (55) are in the form of a liquid crystal display.

3. The personal computer of claim 1, wherein said modulated radiation emitting elements (55) are light emitting diodes.

4. The personal computer of claim 1 wherein said modulated radiation emitting elements (55) are in the form of a cathode ray tube.

5. The personal computer of any preceding claim, wherein the printer (10) is mounted on a drawer carriage (414) such that said printer can be moved slidably into and out of the bay.

6. The personal computer of any preceding claim, wherein the printer (10) further includes a heating element (614) for heating the media uniformly and developing an image.

7. The personal computer of any preceding claim, wherein the printer (10) includes a plurality of rollers (22,32) for conveying said media, a gear train (19), and a motor (35), said motor (35) driving said rollers (22,32) via said gear train (19).

8. The personal computer of any preceding claim, wherein said drive bay includes mounting slots and said printer includes mounting holes (17) for mounting said printer in said bay, said holes (17) being aligned with said mounting slots in said bay.

9. The personal computer of any preceding claim, wherein said printer (10) includes a front face and the media access includes a slot (12) in the front face of the printer (10) for receiving a media supply cartridge (14).

10. The personal computer of any preceding claim, wherein said accessible drive bay is about (1 to 4 inches) 25.4 to 101.6mm high, about (4 to 12 inches) 101.6 to 304.8mm deep, and about (3 to 7 inches) 76.2 to 177.8mm wide.

11. The personal computer of claim 10, wherein said accessible drive bay is a quarter high (3½ inch) 88.9mm disc drive bay.

12. The personal computer of claim 10, wherein said accessible drive bay is a half high (5¼ inch) 133.4mm disc drive bay.

13. The personal computer of any preceding claim, wherein said printer (10) includes a developing head (54) for developing images in said photosensitive media.

14. The personal computer of claim 13, wherein said developing head includes a pressure applicator (70) for applying pressure to said media.

15. The personal computer of claim 13 or 14, wherein said photosensitive media includes a developer and microcapsules containing a colour precursor and a photohardenable composition.

16. A printer (10) which is adapted to be housed within an accessible drive bay of a computer, the printer (10) comprising: a media access (12) for receiving a supply (14) of full colour photosensitive media to be exposed, a communication link for receiving image data from a computer, a printhead (52) for printing said media, and means for mounting said printer in said bay, said printhead (52) comprising a plurality of modulated radiation emitting elements (55) and a motor (66) for driving said printhead (52) along a linear path to scan said media and expose said media to radiation to produce full colour, photographic quality images therein.

17. The printer of claim 16, wherein said modulated radiation emitting elements (55) are in the form of a liquid crystal display.

18. The printer of claim 16, wherein said modulated radiation emitting elements (55) are light emitting diodes.

19. The printer of any one of claims 16 to 18, wherein said bay includes mounting slots and said printer includes mounting holes (17) for mounting said printer to the bay, said holes (17) being aligned with the mounting slots in the bay.

20. The printer of any one of claims 16 to 19, including a front wall having a slot (12) therein for receiving a media cartridge (14) and a pick up roller (22) which contacts the media when a cartridge (14) is inserted through said slot (12) and removes a unit of media from the cartridge (14).

21. The printer of any of claims 16 to 20, including a first motor (66) for driving said printhead and a second motor (35) for driving a conveyor for moving said media with respect to said printhead (52).

22. The printer of any one of claims 16 to 21, wherein the printer (10) is adapted to be housed in an accessible drive bay which is about (1 to 4 inches) 25.4 to 101.6mm high, about (4 to 12 inches) 101.6 to 304.8mm deep, and about (3 to 7 inches) 76.2 to 177.8mm wide.

23. The printer of claim 22, wherein the printer is adapted to be housed in an accessible drive bay which is a half high (5¼ inch) 133.4mm disc drive bay.

24. The printer of claim 22, wherein the printer (10) is adapted to be housed in an accessible drive bay which is a quarter high (3 ½ inch) 88.99mm disc drive bay.

25. The printer of claim 22, wherein the printer (10) is adapted to be housed in an accessible drive bay which is about (1 to 2 inches) 25.4 to 50.8mm high, about (7 to 9 inches) 177.8 to 228.6mm deep and about (5.5 to 6.5 inches) 139.7 to 165.1mm wide.

26. The printer of any one of claims 16 to 25, including a developing head (54) for developing images in said photosensitive media, the developing head (54) including a pressure applicator (70) for applying pressure to said media.

27. The printer of claim 26, wherein said photosensitive media includes a developer and microcapsules containing a colour precursor and a photohardenable composition.

## Patentansprüche

1. Personal-Computer zum Reproduzieren von Vollfarb-Bildern in photographischer Qualität, indem ein lichtempfindliches Medium belichtet und entwickelt wird, wobei der Computer aufweist: ein Gehäuse (T), ein Plattenabteil in dem Gehäuse, auf das zugegriffen werden kann, und einen Drucker (10), wobei der Drucker (10) innerhalb des Plattenabteils untergebracht ist und der Drucker (10) einen Medienzugang (12) zum Empfangen eines Vorrats (14) von lichtempfindlichen Medien für Vollfarbe umfaßt, wobei der Drucker einen Druckkopf (52) umfaßt, welcher eine Vielzahl von modulierte Strahlung emittierenden Elementen (55) aufweist, wobei der Drucker (10) weiter einen Motor (66) zum Treiben des Druckkopfes (52) entlang einem linearen Weg umfaßt, um das Medium abzutasten und das Medium Strahlung auszusetzen, um darin vollfarbige Bilder mit photographischer Qualität zu erzeugen.

2. Personal-Computer nach Anspruch 1, bei dem die modulierte Strahlung emittierenden Elemente (55) in der Form einer Flüssigkristallanzeige vorliegen.

3. Personal-Computer nach Anspruch 1, bei dem die modulierte Strahlung emittierenden Elemente (55) lichtemittierende Dioden sind.

4. Personal-Computer nach Anspruch 1, bei dem die modulierte Strahlung emittierenden Elemente (55) in der Form einer Kathodenstrahlröhre vorliegen.

5. Personal-Computer nach einem der vorangehenden Ansprüche, bei dem der Drucker (10) auf einem Schieberschlitten (414) angeordnet ist, so daß der Drucker gleitend in und aus dem Abteil bewegt werden kann.

6. Personal-Computer nach einem der vorangehenden Ansprüche, bei dem der Drucker (10) weiter ein Heizelement (614) zum gleichförmigen Erwärmen des Mediums und Entwickeln eines Bildes umfaßt.

7. Personal-Computer nach einem der vorangehenden Ansprüche, bei dem der Drucker (10) eine Vielzahl von Walzen (22, 32) zum Transportieren des Mediums, einen Getriebezug (19) und einen Motor (35) umfaßt, wobei der Motor (35) die Walzen (22, 32) über den Getriebezug (19) antreibt.

8. Personal-Computer nach einem der vorangehenden Ansprüche, bei dem das Plattenabteil Montageschlitze umfaßt und der Drucker Montagelöcher (17) zum Anbringen des Druckers in dem Abteil umfaßt, wobei die Löcher (17) mit den Montageschlitzen in dem Abteil ausgerichtet sind.

9. Personal-Computer nach einem der vorangehenden Ansprüche, bei dem der Drucker (10) eine Vorderseite und der Medienzugang einen Schlitz (12) in der Vorderseite des Druckers (10) zum Aufnehmen einer Medienvorratskassette (14) aufweist.

10. Personal-Computer nach einem der vorangehenden Ansprüche, wobei das Plattenabteil, auf das zugegriffen werden kann, etwa (1 bis 4 Zoll) 25.4 bis 101.6 mm hoch, etwa (4 bis 12 Zoll) 101.6 bis 304.8 mm tief und etwa (3 bis 7 Zoll) 76.2 bis 177.8 mm breit ist.

11. Personal-Computer nach Anspruch 10, bei dem das Plattenabteil, auf das zugegriffen werden kann, ein viertelhohes (3 ½ Zoll) 88.9 Disketten-Plattenabteil ist.

12. Personal-Computer nach Anspruch 10, bei dem das Plattenabteil, auf das zugegriffen werden kann, ein halbhohes (5 ¼ Zoll) 133.4 mm Disketten-Plattenabteil ist.

13. Personal-Computer nach einem der vorangehenden Ansprüche, bei dem der Drucker (10) einen Entwicklungskopf (54) zum Entwickeln von Bildern in dem lichtempfindlichen Medium umfaßt.

14. Personal-Computer nach Anspruch 13, bei dem der Entwicklungskopf einen Druckapplikator (70) zum Aufgeben von Druck auf das Medium umfaßt.

15. Personal-Computer nach Anspruch 13 oder 14, bei dem das lichtempfindliche Medium einen Entwickler und Mikrokapseln umfaßt, welche einen Farb-Vorläufer und eine lichthärtende Zusammensetzung enthalten.

16. Drucker (10), der so ausgelegt ist, daß er in einem Plattenabteil eines Computers, auf das zugegriffen werden kann, untergebracht werden kann, wobei der Drucker (10) aufweist: einen Medienzugang (12) zum Empfangen eines Vorrats (14) an lichtempfindlichen Medien für Vollfarbe, die belichtet werden sollen, eine Kommunikationsverbindung zum Empfangen von Bilddaten von einem Computer, einen Druckkopf (52) zum Drucken der Medien und eine Einrichtung zum Anbringen des Druckers in dem Abteil, wobei der Druckkopf (52) eine Vielzahl von modulierte Strahlung emittierenden Elementen (55) und einen Motor (66) zum Treiben des Druckkopfes (52) entlang einem linearen Weg aufweist, um die Medien abzutasten und die Medien Strahlung auszusetzen, um darin vollfarbige Bilder mit photographischer Qualität zu erzeugen.

17. Drucker nach Anspruch 16, bei dem die modulierte Strahlung emittierenden Elemente (55) in der Form einer Flüssigkristallanzeige vorliegen.

18. Drucker nach Anspruch 16, bei dem die modulierte Strahlung emittierende Elemente (55) lichtemittierende Dioden sind.

19. Drucker nach einem der Ansprüche 16 bis 18, bei dem das Abteil Montageschlitze umfaßt und der Drucker Montagelöcher (17) zum Anbringen des Druckers in dem Abteil umfaßt, wobei die Löcher (17) mit den Montageschlitzen in dem Abteil ausgerichtet sind.

20. Drucker nach einem der Ansprüche 16 bis 19, einschließlich einer Vorderwand, welche einen Schlitz (12) darin zum Aufnehmen einer Medienkassette (14) hat, und einer Aufnahmewalze (22), welche in Kontakt mit dem Medium kommt, wenn eine Kassette (14) durch den Schlitz (12) eingeführt wird und eine Einheit des Mediums aus der Kassette (14) entfernt.

21. Drucker nach einem der Ansprüche 16 bis 20, einschließlich eines ersten Motors (66) zum Treiben des Druckkopfes und eines zweiten Motors (35) zum Treiben einer Transportiereinrichtung zum Bewegen der Medien in bezug auf den Druckkopf (52).

22. Drucker nach einem der Ansprüche 16 bis 21, wobei der Drucker (10) so ausgelegt ist, daß er in einem Plattenabteil, auf das zugegriffen werden kann, unterzubringen ist, das etwa (1 bis 4 Zoll) 25.4 bis 101.6 mm hoch, etwa (4 bis 12 Zoll) 101.6 bis 304.8 mm tief und etwa (3 bis 7 Zoll) 76.2 bis 177.8 mm breit ist.

23. Drucker nach Anspruch 22, wobei der Drucker so ausgelegt ist, daß er in einem Plattenabteil, auf das zugegriffen werden kann, unterzubringen ist, das ein halbhohes (5 ¼ Zoll) 133.4 mm Disketten-Plattenabteil ist.

24. Drucker nach Anspruch 22, wobei der Drucker (10) so ausgelegt ist, daß er in einem Plattenabteil, auf das zugegriffen werden kann, unterzubringen ist, das ein viertelhohes (3 ½ Zoll) 88.99 mm Disketten-Plattenabteil ist.

25. Drucker nach Anspruch 22, bei dem der Drucker (10) so ausgelegt ist, daß er in einem Plattenabteil, auf das zugegriffen werden kann, unterzubringen ist, das ungefähr (1 bis 2 Zoll) 25.4 bis 50.8 mm hoch, etwa (7 bis 9 Zoll) 177.8 bis 228.6 mm tief und etwa (5.5 bis 6.5 Zoll) 139.7 bis 165.1 mm breit ist.

26. Drucker nach einem der Ansprüche 16 bis 25, welcher einen Entwicklungskopf (54) zum Entwickeln von Bildern auf den lichtempfindlichen Medien umfaßt, wobei der Entwicklungskopf (54) einen Druckapplikator (70) zum Aufgeben von Druck auf das Medium umfaßt.

27. Drucker nach Anspruch 26, bei dem das lichtempfindliche Medium einen Entwickler und Mikrokapseln umfaßt, welche einen Farb-Vorläufer und eine lichthärtende Zusammensetzung enthalten.

## Revendications

1. Un ordinateur personnel pour reproduire des images de qualité photographique, en pleine couleur, par exposition et développement d'un support photo-sensible, l'ordinateur comprenant : un boîtier (T), une baie d'unité accessible dans le boîtier et une imprimante (10), dans lequel ladite imprimante (10) est logée à l'intérieur de ladite baie d'unité, et ladite imprimante (10) comprend un accès au support (12) pour recevoir une alimentation (14) en support photosensible en pleine couleur, ladite imprimante comprenant une tête d'impression (52) comprenant une pluralité d'éléments émetteurs de rayonnement modulé (55), ladite imprimante (10) comprenant en outre un moteur (66) pour entraîner ladite tête d'impression (52) le long d'une trajectoire linéaire, afin d'explorer ledit support et d'exposer ledit support au rayonnement, afin d'y produire des images de qualité photographique en pleine couleur.

2. L'ordinateur personnel selon la revendication 1, dans lequel lesdits éléments émetteurs de rayonnement modulé (55) se présentent sous la forme d'un affichage à cristaux liquides.

3. L'ordinateur personnel selon la revendication 1, dans lequel lesdits éléments émetteurs de rayonnement modulé (55) sont des diodes photoémettrices.

4. L'ordinateur personnel selon la revendication 1, dans lequel lesdits éléments émetteurs de rayonnement modulé (55) se présentent sous la forme d'un tube à rayons cathodiques.

5. L'ordinateur personnel selon l'une quelconque des revendications précédentes, dans lequel l'imprimante (10) est montée sur un chariot à tiroir (414), de manière que ladite imprimante puisse être déplacée par coulissement pour l'introduire et la sortir de la baie.

6. L'ordinateur personnel selon l'une quelconque des revendications précédentes, dans lequel l'imprimante (10) comprend en outre un élément chauffant (614) pour chauffer uniformément le support et développer une image.

7. L'ordinateur personnel selon l'une quelconque des revendications précédentes, dans lequel l'imprimante (10) comprend une pluralité de rouleaux (22, 32) pour transporter ledits supports, un train d'engrenage (19), et un moteur (35), ledit moteur (35) entraînant lesdits rouleaux (22,32) via ledit train d'engrenage (19).

8. L'ordinateur personnel selon l'une quelconque des revendications précédentes, dans lequel ladite baie d'unité comprend des fentes de montage, et ladite imprimante (10) comprend des trous de montage (17) pour monter ladite imprimante dans ladite baie, lesdits trous étant alignés vis-à-vis desdites fentes de montage dans ladite baie.

9. L'ordinateur personnel selon l'une quelconque des revendications précédentes, dans lequel ladite imprimante (10) comprend une face avant, et l'accès au support comprend une fente (12), ménagée dans la face avant de l'imprimante (10), afin de recevoir un chariot d'alimentation en supports (14).

10. L'ordinateur personnel selon l'une quelconque des revendications précédentes, dans lequel ladite baie d'unité accessible est d'une hauteur d'environ 25.4 à 101.6 mm (1 à 4 pouces), d'une profondeur d'environ 101.6 à 304.8 mm (4 à 12 pouces), et d'une largeur d'environ 76.2 à 177.8 mm (3 à 7 pouces).

11. L'ordinateur personnel selon la revendication 10, dans lequel ladite baie d'unité accessible est une baie d'unité à disque de quart de hauteur, de 88.9 mm (3 pouces 1/2).

12. L'ordinateur personnel selon la revendication 10, dans lequel ladite baie d'unité accessible est une baie d'unité à disque de demi hauteur, de 133.4 mm (5 pouces 1/4).

13. L'ordinateur personnel selon l'une quelconque des revendications, dans lequel ladite imprimante (10) comprend une tête de développement (54) pour développer des images dans ledit support photosensible.

14. L'ordinateur personnel selon la revendication 13, dans lequel ladite tête de développement comprend un applicateur de pressions (70), pour appliquer une pression sur ledit support.

15. L'ordinateur personnel selon la revendication 13 ou 14, dans lequel ledit support photosensible comprend un révélateur et des micro-capsules contenant un précurseur de couleurs et une composition photo-durcissable.

16. Une imprimante (10), adaptée pour être logée dans une baie d'unité accessible d'un ordinateur, l'imprimante (10) comprenant : un accès au support (12) pour recevoir une alimentation (14) en supports photosensibles en pleine couleur devant être exposés, une liaison de communication pour recevoir des données images venant d'un ordinateur, une tête d'impression (52) pour imprimer lesdits supports, et des moyens pour monter ladite imprimante dans ladite baie, ladite tête d'impression (52) comprenant une pluralité d'éléments émetteurs de rayonnement modulé (55) et un moteur (66) pour entraîner ladite tête d'impression (52) le long d'une trajectoire linéaire, afin d'explorer ledit support et d'exposer lesdits supports à un rayonnement pour y produire des images de qualité photographique, en pleine couleur.

17. L'imprimante selon la revendication 16, dans laquelle lesdits éléments émetteurs de rayonnement modulé (55) se présentent sous la forme d'un affichage à cristaux liquides.

18. L'imprimante selon la revendication 16, dans laquelle lesdits éléments émetteurs de rayonnement modulé (55) sont des diodes photoémettrices.

19. L'imprimante selon l'une quelconque des revendications 16 à 18, dans laquelle ladite baie comprend des fentes de montage et ladite imprimante comprend des trous de montage (17) pour monter ladite imprimante sur la baie, lesdits trous (17) étant alignés vis-à-vis des fentes de montage se trouvant dans la baie.

20. L'imprimante selon l'une quelconque des revendications 16 à 19, comprenant une paroi avant ayant en son sein une fente (12), pour recevoir une cartouche à support (14) et un rouleau de prélèvement (22), mis en contact avec les supports lorsqu'une cartouche (14) est insérée par ladite fente (12) et prélevant un exemplaire des supports de la cartouche (14).

21. L'imprimante selon l'une quelconque des revendications 16 à 20, comprenant un premier moteur (66), pour entraîner ladite tête d'impression, et un deuxième moteur (35) pour entraîner un transporteur devant déplacer lesdits supports par rapport à ladite tête d'impression (52).

22. L'imprimante selon l'une quelconque des revendications 16 à 21, dans laquelle l'imprimante (10) est adaptée pour être logée dans une baie d'unité accessible qui est d'une hauteur d'environ 25.4 mm à 101.6 mm (1 à 4 pouces), d'une profondeur d'environ 101.6 mm à 304.8 mm (4 à 12 pouces), et d'une largeur d'environ 76.2 mm à 177.8 mm (3 à 7 pouces).

23. L'imprimante selon la revendication 22, dans laquelle l'imprimante est adaptée pour être logée dans une baie d'unité accessible qui est une baie d'unité à disque de demi-hauteur, 133.4 mm (5 pouces 1/4).

24. L'imprimante selon la revendication 22, dans laquelle l'imprimante (10) est adaptée pour être logée dans une baie d'unité accessible qui est une baie d'unité à disque de quart de hauteur, 88.89 mm (3 pouces 1/2).

25. L'imprimante selon la revendication 22, dans laquelle l'imprimante (10) est adaptée pour être logée dans une baie d'unité accessible qui est d'une hauteur d'environ 25.4 à 50.8 mm (de 1 à 2 pouces), d'une profondeur d'environ 177.8 à 228.6 mm (de 7 à 9 pouces), et d'une largeur d'environ 39.7 à 165 mm (de 5,5 pouces à 6,5 pouces).

26. L'imprimante selon l'une quelconque des revendications 16 à 25, comprenant une tête de développement (54) pour développer des images dans lesdits supports photosensibles, la tête de développement (54) comprenant un applicateur de pression (70) pour appliquer une pression auxdits supports.

27. L'imprimante selon la revendication 26, dans laquelle lesdits supports photosensibles comprennent un révélateur et des micro-capsules, contenant un précurseur de couleur et une composition photo-durcissable.
